# EUROPÄISCHE PATENTSCHRIFT

(11) **EP 2 751 617 B1**
(45) Veröffentlichungstag und Bekanntmachung des Hinweises auf die Patenterteilung: **06.05.2020**
(21) Anmeldenummer: 12740145.3
(22) Anmeldetag: 26.07.2012
(51) Int. Cl.: G03B 21/28, G03B 21/62, G02B 27/01, H04N 9/31, G03B 21/60, G03B 21/20, G02B 1/04, G02B 5/22, G02B 5/30, G02B 26/10, H01S 5/00, H01S 5/068, B32B 17/10, G02B 26/08

(54) **EINE VORRICHTUNG ZUR ERZEUGUNG EINES ANZEIGEBILDES AUF EINER VERBUNDGLASSCHEIBE**
A DEVICE FOR PRODUCING A DISPLAY IMAGE ON A COMPOUND GLASS PANE
DISPOSITIF DE PRODUCTION D'UNE IMAGE D'AFFICHAGE SUR UNE VITRE COMPOSITE

(30) Priorität: 29.08.2011 EP 11179154
(43) Veröffentlichungstag der Anmeldung: 09.07.2014
(73) Patentinhaber: Sekisui Chemical Co., Ltd., Osaka-shi, Osaka 530-8565 (JP)
(72) Erfinder: ALSCHINGER, Matthias, 60200 Compiegne (FR); LABROT, Michael, 52072 Aachen (DE); LETOCART, Philippe, B-4730 Raeren (BE); BERGS, Bianca, 52511 Geilenkirchen (DE); ELMER, Monique, 48282 Emsdetten (DE); LALUET, Jean-Yves, F-75019 Paris (FR); LECAMP, Guillaume, F-75018 Paris (FR); NEANDER, Marcus, 52249 Eschweiler (DE)
(74) Vertreter: Ter Meer Steinmeister & Partner
(86) Internationale Anmeldenummer: PCT/EP2012/064666
(87) Internationale Veröffentlichungsnummer: WO 2013/029888

(56) Entgegenhaltungen:
- EP-A2- 0 734 852
- EP-A2- 2 233 962
- WO-A1-2007/039850
- DE-A1- 10 350 529
- DE-A1-102009 044 181
- FR-A1- 2 929 016
- US-A1- 2001 005 262
- US-A1- 2006 065 735
- US-A1- 2006 244 925

## Beschreibung

Die Erfindung betrifft eine Vorrichtung zur Erzeugung eines Anzeigebildes auf einer Verbundglasscheibe sowie deren Verwendung. Die Erfindung betrifft weiter ein Verfahren zur Erzeugung eines Anzeigebildes auf einer Verbundglasscheibe.

Head-Up-Displays sind in der Luftfahrt weit verbreitet. Die im direkten Sichtfeld der Piloten montierten Systeme zeigen die wichtigsten Informationen des eigenen und der fremden Flugzeuge an. Diese im militärischen Bereich etablierten und vielgenutzten Systeme haben auch im zivilen Bereich, insbesondere im Automobilbereich, viele Anwendungsmöglichkeiten. So können Daten zur Geschwindigkeit, der Abstand zum vorausfahrenden Fahrzeug oder Richtungsangaben des Navigationsgerätes direkt auf Augenhöhe des Fahrers angezeigt werden. Diese Möglichkeiten verbessern deutlich die Verkehrssicherheit des Fahrzeuges, da der Fahrer beim Blick auf die Instrumente die Verkehrslage und -situation nicht beobachten kann. Bei hohen Geschwindigkeiten des Fahrzeugs, beispielsweise auf der Autobahn, kann der "blind" zurückgelegte Fahrzeugweg beträchtlich sein und eine erhöhte Unfallgefahr bedingen.

US 7,230,767 B2 offenbart ein Head-Up-Display für Fahrzeuge. Die Anordnung umfasst eine Verbundglasscheibe, die lumineszierende Verbindungen enthält. Über eine Leuchtquelle, beispielsweise einen Laser, werden die lumineszierenden Verbindungen angeleuchtet und erscheinen im Blickfeld eines Autofahrers. Zur Anregung der lumineszierenden Verbindungen werden hohe Laserleistungen von beispielsweise 100 mW benötigt, die zu einer Schädigung von Augen oder Haut einer Person führen können. Die Laserstrahlung stellt somit eine Gefahr für die Fahrzeuginsassen dar, insbesondere wenn sich ein reflektierendes Objekt, beispielsweise ein Handspiegel, zwischen Laserprojektor und Fahrzeugscheibe befindet. Der Laserstrahl kann durch das reflektierende Objekt beispielsweise in ein Auge eines Fahrzeuginsassen geleitet werden.

Der internationale Standard IEC 60825-1 Edition 2.0 legt eine maximal zulässige Bestrahlung (MZB) oder *maximum permissible exposure* (MPE) fest. Die MZB ist die höchste Leistungsdichte eines Lasers, bei der noch keine Schädigung des Auges auftritt, wenn der Laserstrahl auf das Auge einer Person trifft. Aus der MZB ergibt sich unter Berücksichtigung der bestrahlten Fläche und der Strahlungsleistung eine maximal zulässige Bestrahlungsdauer. Laserstrahlung, die über einen Zeitraum, welcher länger als die maximal zulässige Bestrahlungsdauer ist, auf das Auge einer Person trifft, erzeugt Schädigungen des Auges.

Die Laserstrahlung wird zur Erzeugung eines Bildes typischerweise durch einen oder mehrere verkippbare Spiegel bewegt. Die Gefährdung der Fahrzeuginsassen durch die Laserstrahlung ist besonders groß, wenn beispielsweise eine mechanische Beschädigung zu einem Ausfall der Spiegelbewegung führt. Die Laserstrahlung ist dann auf einen feststehenden Punkt gerichtet. Gelangt die Laserstrahlung in das Auge eines Fahrzeuginsassen, so kann die maximal zulässige Bestrahlungsdauer leicht überschritten werden.

Aus EP 2 233 962 A2 ist ein mittels Laserstrahlung auf einer Windschutzscheibe erzeugtes Anzeigebild bekannt, wobei die Laserstrahlung in regelmäßigen Zeitabständen auf ein reflektierendes Element geleitet wird. Das reflektierende Element ist auf der Windschutzscheibe angeordnet und lenkt die Laserstrahlung auf einen Sensor um. Unterbleibt die Detektion der Laserstrahlung durch den Sensor, so deutet dies auf eine Störung hin und die Laserstrahlung wird unterbrochen. Eine solche Lösung führt zwar zu einer deutlichen Verbesserung der Sicherheit der Fahrzeuginsassen, weist aber eine Reihe von Nachteilen auf. Die Anwesenheit eines Hindernisses zwischen Laserprojektor und Windschutzscheibe wird nicht kontinuierlich überprüft, sondern nur in den Zeiträumen, in denen die Laserstrahlung auf das reflektierende Element geleitet wird. Zudem können nur solche Hindernisse erkannt werden, die sich zwischen Laserprojektor und dem reflektierenden Element befinden. Hindernisse vor anderen Bereichen der Windschutzscheibe werden nicht erkannt. Außerdem ist das Anbringen und genaue Ausrichten des reflektierenden Elements aufwendig und kann das Erscheinungsbild der Windschutzscheibe negativ beeinflussen.

Von Projektionssystemen, bei welchen das Anzeigebild durch diffuse Reflexion und / oder Streuung von Laserstrahlung an einem geeigneten Untergrund, beispielsweise einer Leinwand erzeugt wird, ist bekannt, dass die Gefährdung von Personen durch Detektion der diffus reflektierten und / oder gestreuten Strahlung verringert werden kann. Solche Lösungen sind beispielsweise aus US 2006/0065735 A1, US 2001/0005262 A1 und US 2006/0244925 A1 bekannt. Bei solchen Projektionssystemen können Hindernisse oder sonstige Störungen wie Beschädigungen der Leinwand durch eine Abnahme der detektierten Strahlungsintensität festgestellt werden. Bei einem Head-Up-Display auf einer Glasscheibe kann eine solche Lösung allerdings nicht angewendet werden, weil die glatte Glasoberfläche einen zu geringen diffus reflektierten Strahlungsanteil aufweist. Zudem werden häufig Maßnahmen getroffen, um die (an sich unerwünschte) Reflexion weiter zu verringern.

Aus JP 2009-145846 A ist ein Head-Up-Display bekannt, bei dem Hindernisse durch einen zusätzlichen Lichtstrahl detektiert werden. Die Installation einer weiteren Strahlungsquelle zusätzlich zu derjenigen, welche das Anzeigebild erzeugt, ist allerdings technisch sehr aufwendig.

Die Aufgabe der vorliegenden Erfindung ist es, eine verbesserte Vorrichtung zur Erzeugung eines Anzeigebildes auf einer Verbundglasscheibe bereitzustellen, wobei die Gefährdung der Fahrzeuginsassen durch die Laserstrahlung vermieden wird. Die Aufgabe der vorliegenden Erfindung ist es weiter, ein Verfahren zur Erzeugung eines Anzeigebildes auf einer Verbundglasscheibe bereitzustellen.

Die Aufgabe der vorliegenden Erfindung wird erfindungsgemäß durch eine Vorrichtung zur Erzeugung eines Anzeigebildes auf einer Verbundglasscheibe gemäß dem unabhängigen Anspruch 1 gelöst. Bevorzugte Ausführungen gehen aus den Unteransprüchen hervor.

Die erfindungsgemäße Vorrichtung zur Erzeugung eines Anzeigebildes auf einer Verbundglasscheibe umfasst die folgenden Merkmale:
- eine Verbundglasscheibe mit einer ersten Scheibe und einer zweiten Scheibe, die über eine zumindest ein lumineszierendes Pigment enthaltende Zwischenschicht miteinander verbunden sind,
- einen Laserprojektor, der zumindest einen Laser und ein optisches System zur Lenkung der Strahlung des Lasers enthält, wobei die Strahlung auf die Verbundglasscheibe innerhalb eines Bereichs der Verbundglasscheibe gerichtet wird,
- einen Photodetektor, der Lumineszenzstrahlung des lumineszierenden Pigments detektiert, und
- eine Steuerungseinheit, die den Photodetektor und den Laserprojektor elektronisch verbindet.

Der vom Laserprojektor ausgehende Laserstrahl ist auf die Verbundglasscheibe gerichtet. Der Laserstrahl dringt über die erste Scheibe in die Zwischenschicht ein. Zumindest ein Teil der Laserstrahlung wird beim Durchtritt durch die Zwischenschicht von dem lumineszierenden Pigment absorbiert. Das lumineszierende Pigment wird dabei bevorzugt optisch angeregt und gibt zumindest einen Teil der Anregungsenergie in Form von elektromagnetischer Strahlung wieder ab. Dabei wird Lumineszenzstrahlung vom lumineszierenden Pigment emittiert. Lumineszenz beinhaltet Fluoreszenz- und / oder Phosphoreszenzprozesse. Die Lumineszenzstrahlung weist eine im Vergleich zur Laserstrahlung veränderte, besonders bevorzugt größere, Wellenlänge auf. Die Lumineszenzstrahlung weist erfindungsgemäß eine Wellenlänge im Bereich des sichtbaren Lichts auf.

Bevorzugt wird der überwiegende Teil der Laserstrahlung beim Durchtritt durch die Zwischenschicht von dem lumineszierenden Pigment absorbiert. Dadurch kann eine Gefährdung von Personen aufgrund durch die Scheibe transmittierter Laserstrahlung vorteilhaft vermieden werden.

Die Emission von Lumineszenzstrahlung durch das lumineszierende Pigment erfolgt statistisch verteilt in alle Raumrichtungen. Ein Teil der Lumineszenzstrahlung ist dabei auf das Auge des Betrachters gerichtet und wird somit vom Betrachter als Bildpunkt auf der Scheibe wahrgenommen.

Die Richtung des Laserstrahls kann mittels des optischen Systems des Laserprojektors verändert werden. Der Laserstrahl kann so zumindest über einen Bereich der Verbundglasscheibe bewegt werden. Durch die Bewegung des Laserstrahl über die Verbundglasscheibe wird ein Bild erzeugt, beispielsweise ein Piktogramm, Zahlen und / oder Schriftzeichen. Der Bereich der Verbundglasscheibe, innerhalb dessen erfindungsgemäß ein Bild erzeugt werden soll und innerhalb dessen der Laserstrahl über die Verbundglasscheibe bewegt werden kann, wird als der für die Laserstrahlung zugängliche Bereich der Verbundglasscheibe bezeichnet. Der für die Laserstrahlung zugängliche Bereich der Verbundglasscheibe kann den gesamten Bereich der Verbundglasscheibe umfassen, der nicht durch Objekte zwischen Laserprojektor und Verbundglasscheibe, beispielsweise Befestigungselemente der Verbundglasscheibe, bezüglich des Lasers abgeschattet ist.

Der Photodetektor ist zumindest für elektromagnetische Strahlung aus mindestens einem Teilbereich des Wellenlängenbereichs der Lumineszenzstrahlung des lumineszierenden Pigments empfindlich. Der Photodetektor ist so positioniert und ausgerichtet, dass Lumineszenzstrahlung mindestens aus dem gesamten für die Laserstrahlung zugänglichen Bereich der Verbundglasscheibe detektiert werden kann. Insbesondere dürfen keine Hindernisse für elektromagnetische Strahlung zwischen dem Photodetektor und dem für die Laserstrahlung zugänglichen Bereich der Verbundglasscheibe positioniert sein.

Falls Laserstrahlung den Laserprojektor verlässt und gleichzeitig keine Lumineszenzstrahlung durch den Photodetektor detektiert wird, muss ein Hindernis vor der Verbundglasscheibe angeordnet sein. Das Hindernis kann zwischen Laserprojektor und Scheibe angeordnet sein und die Anregung des lumineszierenden Pigments verhindern Alternativ kann das Hindernis zwischen Photodetektor und Verbundglasscheibe angeordnet sein und die Detektion der Lumineszenzstrahlung verhindern. Ein solches Hindernis ist beispielsweise der Kopf einer Person oder ein reflektierender Gegenstand, etwa ein Handspiegel, der die Laserstrahlung in das Auge einer Person lenken könnte. Zur Vermeidung einer Gefährdung für den Betrachter muss die Laserstrahlung bei Anwesenheit eines Hindernisses vor der Verbundglasscheibe unterbrochen werden. Die Steuerungseinheit unterbricht den Austritt von Laserstrahlung aus dem Laserprojektor, wenn der Photodetektor keine Lumineszenzstrahlung detektiert.

Der Laserprojektor und der Photodetektor sind über die Steuerungseinheit elektronisch miteinander verbunden. Die Steuerungseinheit kann Signale vom Laserprojektor und vom Photodetektor empfangen und verarbeiten. Die Steuerungseinheit enthält bevorzugt eine integrierte Schaltung, beispielsweise einen Mikrocontroller, einen Signalprozessor oder einen FPGA (Field Programmable Gate Array). Die Steuerungseinheit enthält besonders bevorzugt ein anwendungsspezifisches Standardprodukt (application specific standard product, ASSP) oder eine anwendungsspezifische integrierte Schaltung (application-specific integrated circuit, ASIC). Das ist besonders vorteilhaft im Hinblick auf die Geschwindigkeit der Signalverarbeitung.

Der Laserprojektor übermittelt ein Ein-Signal, beispielsweise ein Spannungssignal von 1 V, an die Steuerungseinheit, wenn Laserstrahlung den Laserprojektor verlässt. Der Laserprojektor übermittelt ein Aus-Signal, beispielsweise ein Spannungssignal von 0 V, an die Steuerungseinheit, wenn keine Laserstrahlung den Laserprojektor verlässt. Der Photodetektor übermittelt ein Ein-Signal, wenn Lumineszenzstrahlung detektiert wird, und ein Aus-Signal, wenn keine Lumineszenzstrahlung detektiert wird, an die Steuerungseinheit. Die Steuerungseinheit vergleicht die Signale von Laserprojektor und Photodetektor. Falls ein Ein-Signal des Laserprojektors empfangen wird und gleichzeitig kein Ein-Signal des Photodetektors, muss sich ein Hindernis vor der Verbundglasscheibe befinden. Die Steuerungseinheit unterbricht in diesem Fall den Austritt von Laserstrahlung aus dem Laserprojektor. Eine Gefährdung von Personen durch die Laserstrahlung wird somit durch die erfindungsgemäße Vorrichtung zur Erzeugung eines Anzeigebildes auf einer Verbundglasscheibe vorteilhaft verhindert.

Die Begriffe "Ein-Signal" und "Aus-Signal" sollen den erfinderischen Gedanken verdeutlichen und sind im Sinne der Erfindung breit auszulegen. Es sind darunter nicht nur zwei verschiedene, diskrete Signale zu verstehen. Die Übermittlung des Ein-Signals und des Aus-Signals kann auch die Übermittlung von Rohdaten an die Steuerungseinheit umfassen, beispielsweise die Zahlraten des Photodetektors, welche erst durch die Steuerungseinheit mittels geeigneter Grenzwerte als Ein-Signal beziehungsweise Aus-Signal interpretiert werden. Allgemein ist unter Ein-Signal und Aus-Signal jedes Signal zu verstehen, welches der Steuerungseinheit die Unterscheidung ermöglicht, ob Lumineszenzstrahlung durch den Photodetektor detektiert wird beziehungsweise ob Laserstrahlung den Laserprojektor verlässt.

Die durch den Photodetektor detektierte Lumineszenzstrahlung des lumineszierenden Pigments ist deutlich intensiver als diffus reflektierte und / oder gestreute Anteile der Laserstrahlung. Die Intensität der Lumineszenzstrahlung ist zudem weitgehend unabhängig von der Position der Laserstrahlung auf der Verbundglasscheibe. Hindernisse können daher durch die erfindungsgemäße Vorrichtung deutlich effizienter festgestellt werden als beispielsweise durch Detektion der diffus reflektierten und / oder gestreuten Laserstrahlung. Ein unerwünschter Strahlungsuntergrund, welcher intensitätsschwächer ist als die Lumineszenzstrahlung, beispielsweise hervorgerufen durch diffus reflektierte und / oder gestreute Laserstrahlung oder sonstige Strahlungsquellen, kann beispielsweise durch Einführung eines geeigneten Schwellenwertes des Photodetektors umgangen werden.

Die Unterbrechung des Austritts von Laserstrahlung aus dem Laserprojektor kann beispielsweise durch die Unterbrechung der Spannungsversorgung des Lasers erfolgen. Alternativ kann ein Strahlblocker in den Strahlengang gebracht werden. Der Strahlblocker kann zwischen Laser und optischem System, innerhalb des optischen Systems oder in Richtung der Laserstrahlung hinter dem optischen System angeordnet sein. Die Unterbrechung des Austritts von Laserstrahlung aus dem Laserprojektor kann auch durch elektrooptische oder akustooptische Bauelemente erfolgen.

In einer vorteilhaften Ausgestaltung der Erfindung umfasst der Photodetektor eine Kamera mit einem zweidimensionalen Bildsensor, beispielsweise einem CCD-Sensor. Bevorzugt umfasst der Photodetektor eine Kamera mit einem Active Pixel Sensor (APS-Sensor, CMOS-Sensor). Der besondere Vorteil liegt in der hohen Auslesegeschwindigkeit des APS-Sensors und dem geringen Leistungsbedarf.

Die Position der Laserstrahlung auf der Verbundglasscheibe wird durch das optische System des Laserprojektors festgelegt. Die Position der Laserstrahlung auf der Verbundglasscheibe bestimmt die Position der detektierten Lumineszenzstrahlung auf dem zweidimensionalen Bildsensor der Kamera. In einer besonders bevorzugten Ausgestaltung der Erfindung wird die Information über die vorgesehene Position der Laserstrahlung auf der Scheibe durch die Steuerungseinheit zur Kamera übertragen. Somit muss nicht der gesamte APS-Sensor ausgelesen werden, sondern nur ein Teilbereich des Sensors, der die Position der Lumineszenzstrahlung auf dem APS-Sensor umfasst. Das ist besonders vorteilhaft im Hinblick auf die Auslesegeschwindigkeit.

Die Abfolge nacheinander bestrahlter Pixel oder Pixelgruppen auf dem zweidimensionalen Bildsensor der Kamera kann durch die Steuerungseinheit mit der Form des zu erzeugenden Bildes verglichen werden. Dadurch kann die erfindungsgemäße Funktionsfähigkeit der Vorrichtung zur Erzeugung eines Anzeigebildes auf einer Verbundglasscheibe vorteilhaft überprüft werden.

In einer alternativen vorteilhaften Ausgestaltung der Erfindung umfasst der Photodetektor zumindest einen einpixeligen Photosensor, beispielsweise einen Photowiderstand, einen Phototransistor oder einen Sekundärelektronenvervielfacher, bevorzugt eine Photodiode. Die Photodiode ist eine Halbleiter-Diode, die sichtbares Licht an einem p-n-Übergang oder einem pin-Übergang durch den inneren Photoeffekt in einen elektrischen Strom umgewandelt. Geeignete Halbleitermaterialen zur Detektion im sichtbaren Spektralbereich enthalten beispielsweise Silizium oder III-V-Verbindungshalbleiter wie Arsenide, Phosphide oder Nitride von Gallium, Aluminium und / oder Indium Der besondere Vorteil einer Photodiode liegt in der kurzen Reaktionszeit.

In einer bevorzugten Ausgestaltung der Erfindung wird der vom Laserprojektor ausgehende Laserstrahl periodisch unterbrochen, beispielsweise durch einen Chopper. Die von dem Photodetektor detektierte Strahlung in den Phasen mit unterbrochener Laserstrahlung kann von der detektierten Strahlung in den Phasen, in denen die lumineszierenden Pigmente in der Scheibe angeregt werden, subtrahiert werden. Dadurch wird der störende Einfluss von externen Lichtquellen, beispielsweise des Tageslichts oder von Warnleuchten von Feuerwehr oder Polizei ("Blaulicht"), vorteilhaft vermindert. Das Signal-Rausch-Verhältnis kann mittels eines Lock-in-Verstärkers verbessert werden.

In einer weiteren bevorzugten Ausgestaltung der Erfindung wird das Signal-Rausch-Verhältnis des Photodetektors mit einer Optimalfilter-Methode (matched filter) verbessert. Dabei wird die Laserstrahlung mit einer charakteristischen, sich periodisch wiederholenden Pulsfolge vom Laserprojektor ausgesandt. Die Pulsfolge kann beispielsweise durch einen Chopper oder durch Unterbrechungen der Spannungsversorgung des Lasers erzeugt werden. Die von der Verbundglasscheibe ausgehende Lumineszenzstrahlung erfolgt dann mit der gleichen charakteristischen Pulsfolge. Das Signal des Photodetektors wird auf das Vorhandensein der charakteristischen Pulsfolge analysiert. Dadurch kann die Lumineszenzstrahlung vorteilhaft vom Strahlungsuntergrund unterschieden werden.

Der durch den Photodetektor detektierbare Wellenlängenbereich ist an den Wellenlängenbereich der Lumineszenzstrahlung des lumineszierenden Pigments angepasst. Das wird erfindungsgemäß durch geeignete Spektralfilter vor der aktiven Fläche des Photodetektors erreicht. Der störende Einfluss anderer Lichtquellen wird damit vorteilhaft vermindert. Eine solche andere Lichtquelle kann beispielsweise auch der Laser sein, wenn ein Anteil der Laserstrahlung reflektiert oder gestreut wird.

Der Photodetektor kann zudem Linsen und / oder weitere optische, elektronische oder mechanische Komponenten enthalten.

Der Laserprojektor enthält zumindest einen Laser als Strahlungsquelle und ein optisches System, welches die Richtung der Laserstrahlung und damit die beleuchtete Stelle auf der Verbundglasscheibe festlegt.

Das optische System des Laserprojektors umfasst zumindest einen Spiegel, der mit einem bewegbaren Bauteil verbunden ist. Das bewegbare Bauteil kann beispielsweise zumindest ein Piezoelement enthalten. Bevorzugt enthält das bewegbare Bauteil ein Bauteil nach dem Mikrosystem-Prinzip (Micro-Electro-Mechanical System, MEMS). Spiegel und bewegbares MEMS-Bauteil bilden einen sogenannten Mikrospiegelaktor, genauer einen sogenannten Mikroscanner. Der besondere Vorteil liegt in einer geringen Größe, einem geringen Gewicht, einer geringen Leistungsaufnahme und einer Robustheit gegen Umgebungseinflüsse.

Durch das bewegbare Bauteil kann der Spiegel in zwei Richtungen, bevorzugt zwei zueinander orthogonalen Richtungen, besonders bevorzugt horizontal und vertikal, verkippt werden. Das optische System kann auch mehrere mit jeweils einem bewegbaren Bauteil verbundene Spiegel enthalten. Beispielsweise kann das optische System zwei Spiegel umfassen, wobei ein Spiegel in horizontaler Richtung und der andere Spiegel in vertikaler Richtung verkippt werden kann. Das optische System kann zudem weitere mechanische, elektronische und / oder optische Bauteile, beispielsweise Linsen, umfassen.

Die Ausrichtung des Spiegels legt die Zielposition der Laserstrahlung auf der Verbundglasscheibe fest. Die Zielposition der Laserstrahlung auf der Verbundglasscheibe wird durch die Laserstrahlung angeleuchtet, falls Laserstrahlung den Laserprojektor verlässt.

Die Zielposition der Laserstrahlung auf der Verbundglasscheibe wird zur Erzeugung eines Bildes innerhalb des für die Laserstrahlung zugänglichen Bereichs der Verbundglasscheibe bewegt. Wenn die Zielposition der Laserstrahlung auf der Verbundglasscheibe innerhalb der Fläche des zu erzeugenden Bildes angeordnet ist, verlässt Laserstrahlung den Laserprojektor und trifft auf die Verbundglasscheibe. Wenn die Zielposition der Laserstrahlung auf der Verbundglasscheibe nicht innerhalb der Fläche des zu erzeugenden Bildes angeordnet ist, verlässt keine Laserstrahlung den Laserprojektor.

In einer bevorzugten Ausgestaltung der Erfindung wird das Bild auf der Verbundglasscheibe durch ein Rasterscan-Verfahren erzeugt. Dabei wird die Zielposition der Laserstrahlung auf der Verbundglasscheibe bevorzugt zeilenweise periodisch über zumindest einen Teil des für die Laserstrahlung zugänglichen Bereichs der Verbundglasscheibe bewegt. Der Abstand zweier benachbarter Zeilen kann gleich der Breite des Laserstrahls auf der Verbundglasscheibe sein. Alternativ kann der Abstand zweier benachbarter Zeilen kleiner oder größer als die Breite des Laserstrahls auf der Verbundglasscheibe sein. Der besondere Vorteil des Rasterscan-Verfahrens liegt in einer homogenen Verteilung der Laserstrahlung im Bereich des zu erzeugten Bildes. Dadurch wird eine homogene Helligkeit des Bildes erreicht.

In einer weiteren bevorzugten Ausgestaltung der Erfindung wird das Bild auf der Verbundglasscheibe durch ein vektorielles Scan-Verfahren erzeugt. Dabei wird die Form des zu erzeugenden Bildes durch die Bewegung der Zielposition der Laserstrahlung auf der Verbundglasscheibe nachgebildet. Die Zielposition ist dabei während der gesamten Zeit der Bewegung der Laserstrahlung innerhalb der Fläche des zu erzeugenden Bildes auf der Verbundglasscheibe lokalisiert, wenn das Bild eine einzige zusammenhängende Fläche aufweist (wie beispielsweise die Zahl "0"). Somit verlässt Laserstrahlung den Laserprojektor während der gesamten Zeit der Bewegung der Laserstrahlung. Daraus ergibt sich vorteilhaft eine hohe Anregungsrate des lumineszierenden Pigments und eine hohe Helligkeit des Bildes. Bei der Erzeugung eines Bildes, das mehrere voneinander getrennte Flächen aufweist (wie beispielsweise die Zahl "10"), ist die vorgesehene Position des Laserstrahls auf der Verbundglasscheibe während des überwiegenden Teils der Zeit der Laserbewegung innerhalb der Fläche des zu erzeugenden Bildes lokalisiert.

Das Bild kann auch durch Kombinationen aus vektoriellen Scan-Verfahren und Rasterscan-Verfahren erzeugt werden.

Der Laser ist bevorzugt ein Diodenlaser. Der Laser emittiert bevorzugt elektromagnetische Strahlung mit einer Wellenlänge von 360 nm bis 420 nm. Ein geeigneter kommerziell erhältlicher Diodenlaser ist beispielsweise ein Diodenlaser mit einer Emissionswellenlänge von etwa 405 nm.

In einer besonders vorteilhaften Ausgestaltung der Erfindung emittiert der Laser elektromagnetische Strahlung mit einer Wellenlänge von 375 nm bis 400 nm, beispielsweise 395 nm. Das ist vorteilhaft im Hinblick auf die Anregung von lumineszierenden Pigmenten mit Emissionswellenlängen im sichtbaren Spektralbereich. Die Wellenlänge der Laserstrahlung liegt dabei im UV-A-Bereich des elektromagnetischen Spektrums. Der besondere Vorteil liegt in einer höheren maximal zulässigen Bestrahlung im UV-A-Bereich (315 nm bis 400 nm) als im sichtbaren Bereich (400 nm bis 780 nm). Die höhere maximal zulässige Bestrahlung ergibt sich aus einem anderen Wirkmechanismus der Strahlung im Auge. UV-A-Strahlung wirkt auf die Augenlinse, sichtbare Strahlung wirkt auf die Netzhaut des Auges. Die höhere maximal zulässige Bestrahlung ergibt bei gleicher Bestrahlungsstärke eine längere maximal zulässige Bestrahlungsdauer im UV-A-Bereich als im sichtbaren Bereich. Beispielsweise beträgt die maximal zulässige Bestrahlungsdauer bei einer Bestrahlungsstärke von 1 x 10⁶ W/m² im sichtbaren Bereich unter 1 x 10⁻⁸ s und im UV-A-Bereich über 1 x 10⁻³ s. Dadurch wird die erforderliche Reaktionszeit, innerhalb derer die Laserstrahlung nach Feststellen eines Hindernisses zwischen Laserprojektor und Verbundglasscheibe unterbrochen werden muss, vorteilhaft verlängert.

Der Laserprojektor kann auch mehrere Laser enthalten. Die verschiedenen Laser können die gleiche Emissionswellenlänge oder unterschiedliche Emissionswellenlängen aufweisen.

Die Leistung der Laserstrahlung bei Austritt aus dem Laserprojektor beträgt bevorzugt von 5 mW bis 1000 mW, besonders bevorzugt von 50 mW bis 600 mW. Das ist besonders vorteilhaft im Hinblick auf die Erzeugung eines ausreichend hellen Bildes.

Die durch den Laser emittierte elektromagnetische Strahlung ist typischerweise linear polarisiert. Bei linearer Polarisation ist die Richtung der Schwingung des elektrischen Feldes konstant. Betrag und Vorzeichen des elektrischen Feldes ändern sich periodisch. Die ausgezeichnete Schwingungsrichtung wird als Polarisationsrichtung bezeichnet. Linear polarisiertes Licht kann in zwei Komponenten gleicher Frequenz und gleicher Ausbreitungsrichtung zerlegt werden, die mit gleicher Amplitude und in Phase senkrecht zueinander schwingen. Das Intensitätsverhältnis der beiden Komponenten wird als Polarisationsverhältnis bezeichnet. Das Polarisationsverhältnis beträgt erfindungsgemäß bevorzugt mindestens 50:1, besonders bevorzugt mindestens 90:1.

In einer vorteilhaften Ausgestaltung der Erfindung ist die Laserstrahlung bezogen auf die Oberfläche der Verbundglasscheibe parallel (p-) polarisiert oder vorwiegend p-polarisiert. P-polarisiert bedeutet, dass die Polarisationsrichtung beim Auftreffen der Laserstrahlung auf die Verbundglasscheibe in der Einfallsebene liegt. Die Einfallsebene wird dabei durch den Einfallsvektor und die Oberflächennormale der Verbundglasscheibe an der Stelle, an der die Laserstrahlung auf die Verbundglasscheibe trifft, aufgespannt. P-polarisierte Laserstrahlung wird an der Oberfläche der Verbundglasscheibe verstärkt gebrochen anstatt reflektiert. Das ist besonders vorteilhaft in Bezug auf die Verminderung von Reflexionen der Laserstrahlung an der Verbundglasscheibe, welche den Betrachter stören oder sogar gefährden könnten. Zudem trifft ein größerer Anteil der Laserstrahlung auf die Zwischenschicht der Verbundglasscheibe mit dem lumineszierenden Pigment. Dadurch wird die Anregungsrate des lumineszierenden Pigments vorteilhaft erhöht. Die Polarisationsrichtung kann durch Drehung des Lasers um die durch die Emissionsrichtung gegebene Achse eingestellt werden. Alternativ kann die Polarisationsrichtung beispielsweise durch eine λ/2-Wellenplatte eingestellt werden.

Der Laserprojektor kann zum Erreichen eines hohen Polarisationsverhältnisses auch einen oder mehrere Polarisatoren, beispielsweise Polarisationsfilter, enthalten.

Der Reflexionsgrad der linear polarisierten Laserstrahlung ist abhängig vom Einfallswinkel der Laserstrahlung auf die Oberfläche der Verbundglasscheibe. Der Reflexionsgrad ist das Verhältnis von reflektierter Strahlungsleistung zu eingestrahlter Strahlungsleistung. Der Einfallswinkel ist der Winkel zwischen dem Einfallsvektor und der Oberflächennormale der Verbundglasscheibe an der Stelle, an der die Laserstrahlung auf die Oberfläche der Verbundglasscheibe trifft. Die Verminderung von Reflexionen der linear polarisierten Laserstrahlung ist besonders ausgeprägt, wenn der Einfallswinkel gleich dem sogenannten Brewster-Winkel ist. Bei Lichteinfall unter dem Brewster-Winkel beträgt der Reflexionsgrad für p-polarisierte Strahlung gleich Null. Der Brewster-Winkel an einem erfindungsgemäß bevorzugt auftretenden Luft-Glas-Übergang beträgt etwa 57,2°.

In einer besonders vorteilhaften Ausgestaltung der Erfindung beträgt der Einfallswinkel, unter dem die Laserstrahlung auf die Oberfläche der Verbundglasscheibe trifft, im gesamten für die Laserstrahlung zugänglichen Bereich der Verbundglasscheibe zwischen 20° und 70°. Der Reflexionsgrad ist dabei typischerweise kleiner oder gleich 0,04. Ganz besonders bevorzugt beträgt der Einfallswinkel zwischen 38° und 66°. Der Reflexionsgrad ist dabei typischerweise kleiner oder gleich 0,02. Das ist besonders vorteilhaft in Bezug auf die Vermeidung von störenden Reflexionen an der Oberfläche der Verbundglasscheibe.

In einer weiteren vorteilhaften Ausgestaltung der Erfindung ist auf der zum Laserprojektor hingewandten Oberfläche der ersten Scheibe der Verbundglasscheibe eine Antireflex-Beschichtung angeordnet. Dadurch werden Reflexionen der Laserstrahlung an der Verbundglasscheibe vorteilhaft vermindert und die Anregungsrate des lumineszierenden Pigments vorteilhaft erhöht. Die Antireflex-Beschichtung umfasst bevorzugt eine poröse Schicht, die Siliziumdioxid enthält. Der besondere Vorteil liegt in einer Unabhängigkeit der reflexionsmindernden Eigenschaften vom Einfallswinkel der Laserstrahlung auf die Verbundglasscheibe. Die poröse Schicht kann beispielsweise durch ein Ätzverfahren hergestellt werden, wie es beispielsweise in DE822714B offenbart ist. Alternativ kann die poröse Schicht beispielsweise in einem Sol-Gel-Verfahren aus einer kolloid-dispersen Lösung aufgebracht werden. Geeignete Verfahren sind beispielsweise in DE19918811A1 und GB2424382A offenbart. Die reflexionsmindernden Eigenschaften sind besonders bevorzugt auf die verwendete Emissionswellenlänge des Lasers optimiert, was durch die Wahl der Schichtdicke der Antireflex-Beschichtung erreicht werden kann. Die reflexionsmindernden Eigenschaften sind optimal, wenn die Schichtdicke der Antireflexbeschichtung ein Viertel der Emissionswellenlänge des Lasers oder ein ungeradzahliges Vielfaches eines Viertels der Emissionswellenlänge des Lasers beträgt.

In einer vorteilhaften Ausgestaltung der Erfindung umfasst die Vorrichtung zur Erzeugung eines Anzeigebildes auf einer Verbundglasscheibe weiter zumindest einen im mittleren Infrarot-Wellenlängenbereich empfindlichen Photodetektor, bevorzugt einen Phototransistor oder eine Photodiode. Der Infrarot-Photodetektor ist bevorzugt in einem Wellenlängenbereich von 4 µm bis 10 µm empfindlich. In diesem Wellenlängenbereich weist die Verbundglasscheibe bevorzugt keine oder eine sehr geringe Transmission auf. Geeignete Halbleitermaterialien für die Photodiode sind beispielsweise CdTe- oder GeAu-Verbindungen. Der Infrarot-Photodetektor ist so positioniert und ausgerichtet, dass von der Verbundglasscheibe ausgehende Infrarot-Strahlung aus bevorzugt zumindest dem für die Laserstrahlung zugänglichen Bereich der Verbundglasscheibe detektiert wird. Besonders bevorzugt wird Infrarot-Strahlung aus lediglich dem für die Laserstrahlung zugänglichen Bereich der Verbundglasscheibe detektiert. Dazu kann die Richtcharakteristik des Infrarot-Photodetektors durch bauliche Elemente, beispielsweise Blenden beeinflusst werden.

Der Infrarot-Photodetektor detektiert bevorzugt die von der Verbundglasscheibe ausgehende Wärmestrahlung. Der Infrarot-Photodetektor ist bevorzugt im Rahmen der baulichen Realisierbarkeit in möglichst geringem Abstand zum Ort des Austritts der Laserstrahlung aus dem Laserprojektor angeordnet.

Der Infrarot-Photodetektor ist bevorzugt mit der Steuerungseinheit verbunden. Ein Hindernis, das vor die Verbundglasscheibe bewegt wird, führt zu einer plötzlichen Änderung der vom Infrarot-Photodetektor detektierten Infrarot-Strahlung. Bei einer plötzlichen Änderung der detektierten Infrarot-Strahlung wird der Austritt von Laserstrahlung aus dem Laserprojektor durch die Steuerungseinheit unterbrochen. Der besondere Vorteil liegt in einer weiteren Verminderung der Gefährdung eines menschlichen Betrachters durch die Laserstrahlung. Insbesondere kann ein Hindernis vor der Verbundglasscheibe bereits vor dem Einschalten der Laserstrahlung festgestellt werden.

In einer alternativen bevorzugten Ausgestaltung der Erfindung detektiert der Infrarot-Photodetektor die an der Scheibe reflektierte Strahlung einer Infrarot-Strahlungsquelle, beispielsweise einer Leuchtdiode oder einer mit einem geeigneten Spektralfilter kombinierten Glühlampe. Dabei werden von dem Infrarot-Photodetektor bevorzugt diffus reflektierte Strahlungsanteile detektiert. Die Infrarot-Strahlungsquelle emittiert bevorzugt Infrarot-Strahlung innerhalb des Wellenlängenbereichs von 4 µm bis 10 µm. Die Infrarot-Strahlung kann dabei den gesamten Wellenlängenbereich von 4 µm bis 10 µm umfassen. Alternativ kann die Infrarot-Strahlung einen Teilbereich des Wellenlängenbereichs von 4 µm bis 10 µm, beispielsweise eine Emissionslinie um 5 µm mit einer Halbwertsbreite von 0,05 µm. Der gesamte von der Infrarot-Strahlungsquelle emittierte Wellenlängenbereich kann auch über den Wellenlängenbereich von 4 µm bis 10 µm hinausgehen. Bevorzugt wird zumindest der gesamte für die Laserstrahlung zugängliche Bereich der Verbundglasscheibe von der Infrarot-Strahlungsquelle ausgeleuchtet. Die Infrarot-Strahlungsquelle ist bevorzugt im Rahmen der baulichen Realisierbarkeit in möglichst geringem Abstand zum Ort des Austritts der Laserstrahlung aus dem Laserprojektor angeordnet. Die Infrarot-Strahlungsquelle kann auch innerhalb des Laserprojektors angeordnet sein. Eine plötzliche Änderung der vom Infrarot-Photodetektor detektierten Strahlung weist auch in dieser Ausgestaltung auf ein Hindernis der Verbundglasscheibe hin. In diesem Fall wird der Austritt von Laserstrahlung aus dem Laserprojektor durch die Steuerungseinheit vorteilhaft unterbrochen.

Die Möglichkeit, ein Hindernis vor der Verbundglasscheibe mittels des Infrarot-Photodetektors und optional der Infrarot-Strahlungsquelle festzustellen, ist unabhängig von dem für die Lumineszenzstrahlung des lumineszierenden Pigments empfindlichen Photodetektor. Es ist demnach prinzipiell denkbar, eine verminderte Gefährdung eines Betrachters durch die Laserstrahlung alleine durch den Infrarot-Photodetektor und optional die Infrarot-Strahlungsquelle bereitzustellen.

In einer alternativen vorteilhaften Ausgestaltung der Erfindung umfasst die Vorrichtung zur Erzeugung eines Anzeigebildes auf einer Verbundglasscheibe weiter zumindest eine Ultraschall-Quelle und einen Ultraschall-Detektor. Ultraschall-Quelle und Ultraschall-Detektor sind bevorzugt mit der Steuerungseinheit verbunden. Der Ultraschall-Detektor sendet in regelmäßigen Zeitabständen ein Ultraschall-Signal aus. Die Wiederholperiode des Ultraschallsignals beträgt bevorzugt von 0,5 ms bis 10 ms. Das Ultraschall-Signal trifft nach Reflexion an der Verbundglasscheibe auf den Ultraschalldetektor. Der Zeitabstand zwischen Aussendung und Detektion des Ultraschall-Signals wird durch die vom Ultraschall-Signal zurückgelegte Strecke von der Ultraschall-Quelle zur Verbundglasscheibe und von der Verbundglasscheibe zum Ultraschall-Detektor bestimmt. Die Steuerungseinheit überprüft den Zeitabstand zwischen Aussendung und Detektion des Ultraschall-Signals. Wenn sich ein Hindernis vor der Verbundglasscheibe befindet, wird das Ultraschall-Signal an dem Hindernis reflektiert und nach einer kürzeren Zeitdauer auf den Ultraschall-Detektor. In diesem Fall wird der Austritt von Laserstrahlung aus dem Laserprojektor durch die Steuerungseinheit unterbrochen. Der besondere Vorteil liegt in einer weiteren Verminderung der Gefährdung eines menschlichen Betrachters durch die Laserstrahlung. Insbesondere kann ein Hindernis vor der Verbundglasscheibe bereits vor dem Einschalten der Laserstrahlung festgestellt werden.

Die Möglichkeit, ein Hindernis vor der Verbundglasscheibe mittels des Ultraschall-Detektors und der Ultraschall-Quelle festzustellen, ist unabhängig von dem für die Lumineszenzstrahlung des lumineszierenden Pigments empfindlichen Photodetektor. Es ist demnach prinzipiell denkbar, eine verminderte Gefährdung eines Betrachters durch die Laserstrahlung alleine durch den Ultraschall-Detektor und die Ultraschall-Quelle bereitzustellen.

Die erfindungsgemäße Verbundglasscheibe umfasst zumindest eine erste Scheibe und eine zweite Scheibe, die über eine Zwischenschicht miteinander verbunden sind.

Die Scheiben enthalten bevorzugt Flachglas (Floatglas), Quarzglas, Borosilikatglas oder Kalk-Natron-Glas. Die Scheiben weisen bevorzugt eine mittlere Lichttransmission (wenn nicht anders spezifiziert als Lichttransmission für die Lichtart A und einem 2° - Normalbeobachter nach DIN 5033 für Licht der Wellenlängen von 380 nm bis 780 nm) von mehr als 80 %, bevorzugt mehr als 90 % auf. Die Scheiben weisen bevorzugt eine Lichttransmission von > 70 %, besonders bevorzugt 75 % im Wellenlängenbereich von 360 nm bis 420 nm auf.

Die erste Scheibe und / oder die zweite Scheibe weisen bevorzugt eine Dicke von 1 mm bis 4 mm, besonders bevorzugt 1,4 mm bis 2,5 mm auf. Die erste Scheibe und die zweite Scheibe können unterschiedliche Dicken aufweisen.

Die erste Scheibe und / oder zweite Scheibe weisen bevorzugt eine Tönung und / oder Beschichtung auf. Die Tönung und / oder Beschichtung können den Kontrast des projizierten Bildes verstärken und die lumineszierenden Pigmente vor Alterung schützen. Die zweite, vom Laserprojektor abgewandte Scheibe enthält bevorzugt eine Tönung und / oder Beschichtung und die erste, zum Laserprojektor hingewandte Scheibe keine Tönung und / oder Beschichtung.

Die Zwischenschicht enthält bevorzugt zumindest ein thermoplastisches Polymer, besonders bevorzugt zumindest Polyvinylbutyral (PVB). Die Zwischenschicht kann auch Polyethylenterephthalat (PET), Polyvinylchlorid (PVC), Polyurethan (PU) und / oder Poly-Ethylvinylacetat (EVA) enthalten. Die Zwischenschicht kann auch Mischungen oder Copolymere verschiedener Polymere enthalten.

Die Zwischenschicht weist bevorzugt eine Dicke von 0,30 mm bis 0,9 mm, bevorzugt 0,50 mm bis 0,80 mm auf. In diesem Bereich für die Schichtdicke werden gute Ergebnisse erzielt.

Die Zwischenschicht weist bevorzugt eine Lichttransmission von > 70 %, bevorzugt > 80 % im Wellenlängenbereich von 390 nm bis 410 nm auf. Die Lichttransmission der Zwischenschicht kann über Foliendicke, Polymerzusammensetzung, Polymerisierungrad, Polymerisierungsverteilung, UV-Blocker oder Weichmacher eingestellt werden. Die erfindungsgemäße Zwischenschicht ermöglicht eine nur geringe Schwächung der anregenden und emittierten elektromagnetischen Strahlung und somit eine hohe Leuchtkraft des Head-Up-Displays.

Die Zwischenschicht kann auch mehrere Einzelschichten umfassen.

Die Zwischenschicht kann eine oder mehrere Sperrschichten gegen die Diffusion des lumineszierenden Pigments umfassen. Sperrschichten enthalten bevorzugt Polybutylenterephthalat (PBT), Polycarbonat (PC), Polyethylenterephthalat (PET) und Polyethylennaphthalat (PEN), Polyvinylchlorid (PVC), Polyvinylfluorid (PVF), Polyvinylbutyral (PVB) ohne Weichmacher und / oder Copolymere davon, besonders bevorzugt Polyethylenterephthalat (PET).

Die Zwischenschicht kann weitere funktionale Schichten, beispielsweise beheizbare Schichten, Beschichtungen mit Antennenfunktion und / oder Beschichtungen niedriger Emissivität umfassen.

Die erfindungsgemäße Zwischenschicht enthält zumindest ein lumineszierendes Pigment. Lumineszierende Pigmente enthalten im Sinne der Erfindung organische und/oder anorganische chromophore oder lumineszierende Verbindungen, Ionen, Aggregate und/oder Moleküle.

Wenn die Zwischenschicht mehrere Einzelschichten umfasst, kann das lumineszierende Pigment in einer oder in mehreren der Einzelschichten enthalten sein. Es können auch verschiedene lumineszierende Pigmente in verschiedenen Einzelschichten der Zwischenschicht enthalten sein.

Das lumineszierende Pigment weist bevorzugt ein lokales Anregungsmaximum im Bereich von 350 nm bis 450 nm, besonders bevorzugt 390 nm bis 420 nm auf. In diesem Bereich werden gute Ergebnisse erzielt.

Das lumineszierende Pigment weist bevorzugt ein lokales Emissionsmaximum im Bereich von 400 nm bis 800 nm, besonders bevorzugt 430 nm bis 500 nm auf. In diesem Bereich werden gute Ergebnisse erzielt.

Das lumineszierende Pigment enthält bevorzugt ein Hydroxyalkylterephthalat mit der Formel: R₁-COO-Ph(OH)ₓ-COO-R₂, wobei R₁, R₂ ein Alkyl- oder Allylrest mit 1 bis 10 C-Atomen ist, Ph ein Phenylring ist, OH eine am Phenylring gebundene Hydroxylgruppe ist und x eine ganze Zahl von 0 bis 4 ist. Die allgemeine Strukturformel ist:

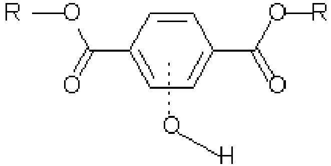

Das lumineszierende Pigment enthält bevorzugt Diethyl-2,5-dihydroxyterephthalat. Die Strukturformel ist:

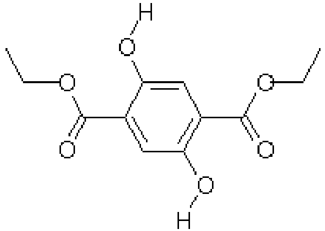

Das lumineszierende Pigment kann auch Benzopyrane, Naphthopyrane, 2H-Naphthopyrane, 3H-Naphthopyrane, 2H-Phenanthropyrane, 3H-Phenanthropyrane, Photochrome Harze, Cumarine, Xanthine, Naphthalinsäurederivate, Oxazole, Stilbene, Styryle, Perylene, Naphthalimide, Naphthale, Phenyle, Xanthene, Lanthanoide, bevorzugt Y2O3:Eu, YVO4:Tm, Y2O2S:Pr, Gd2O2S:Tb und / oder Gemische davon enthalten.

Das lumineszierende Pigment wird zur Herstellung der Verbundglasscheibe bevorzugt mit einem Lösungsmittel auf die Zwischenschicht oder eine Einzelschicht der Zwischenschicht aufgetragen, beispielsweise durch Aufsprühen, Siebdruck, Offsetdruck, Tintenstrahldruck und / oder Flexodruck. Das Lösungsmittel enthält bevorzugt Alkohole, Ketone, Ester, Amine, Amide und / oder Gemische davon. Das Lösungsmittel enthält besonders bevorzugt Ethanol, Tetrahydrofuran und / oder Benzylalkohol. Der größte Anteil der Lösungsmittel geht durch Verdampfen nach dem Auftragen des lumineszierenden Pigments verloren. Beim Laminieren der Zwischenschicht zwischen der ersten und der zweiten Scheibe verteilt sich das lumineszierende Pigment bevorzugt gleichmäßig in der gesamten Zwischenschicht oder einer oder mehrerer Einzelschichten der Zwischenschicht. Das Laminieren erfolgt bevorzugt bei Temperaturen von 120 °C bis 170 °C, einem Druck von 10 bar bis 15 bar und für einen Zeitraum von 30 min bis 240 min.

Die Zwischenschicht enthält bevorzugt 0,1 g/m² bis 15 g/m² lumineszierendes Pigment. Die Mengenangaben beziehen sich auf eine Dicke der Zwischenschicht von etwa 0,76 mm. In diesem Bereich werden gute Ergebnisse erzielt.

Die Aufgabe der Erfindung wird weiter durch ein Verfahren zur Erzeugung eines Anzeigebildes auf einer Verbundglasscheibe gelöst, wobei
- die Strahlung eines Lasers durch ein optisches System eines Laserprojektors auf eine zumindest ein lumineszierendes Pigment enthaltende Verbundglasscheibe gerichtet wird und vom Laserprojektor ein Ein-Signal an eine Steuerungseinheit übermittelt wird, wenn Laserstrahlung den Laserprojektor verlässt,
- von einem Photodetektor ein Ein-Signal an die Steuerungseinheit übermittelt wird, wenn Lumineszenzstrahlung des lumineszierenden Pigments aus dem für die Strahlung des Lasers zugänglichen Bereich der Verbundglasscheibe detektiert wird, und
- die Steuerungseinheit den Austritt von Laserstrahlung aus dem Laserprojektor unterbricht, wenn das Ein-Signal des Laserprojektors und gleichzeitig kein Ein-Signal des Photodetektors von der Steuerungseinheit empfangen wird.

Die Gefährdung des Betrachters durch die Laserstrahlung ist bei einer Störung der Spiegelbewegung und damit einem feststehenden Laserstrahl besonders groß. In einer vorteilhaften Ausgestaltung der Erfindung wird die Beweglichkeit des verkippbaren Spiegels des optischen Systems des Laserprojektors in regelmäßigen Zeitabständen überprüft. Dazu wird durch den Laserprojektor ein regelmäßiges Signal hervorgerufen, wobei die Beweglichkeit des Spiegels zur Erzeugung des Signals erforderlich ist. Beispielsweise wird vom Laserprojektor regelmäßig eine vorgegebene Position auf der Verbundglasscheibe, bevorzugt im Randbereich des für die Laserstrahlung zugänglichen Bereichs der Verbundglasscheibe angeleuchtet. Die Frequenz, mit der die vorgegebene Position auf der Verbundglasscheibe angeleuchtet wird, beträgt bevorzugt von 30 Hz bis 50 Hz. Das ist besonders vorteilhaft im Hinblick auf eine schnelle Reaktionsfähigkeit bei mangelnder Beweglichkeit des Spiegels sowie auf die Vermeidung von Schädigungen des mit dem Spiegel verbundenen beweglichen Bauteils. Durch eine Kamera als Photodetektor wird das Auftreten eines regelmäßigen Signals an der entsprechenden Position auf dem zweidimensionalen Bildsensor analysiert. Bei einem Ausbleiben des regelmäßigen Signals wird der Austritt von Laserstrahlung aus dem Laserprojektor vorteilhaft unterbrochen.

In einer alternativen vorteilhaften Ausgestaltung der Erfindung wird der Laserstrahl regelmäßig auf eine vorgegebene Position innerhalb des Laserprojektors gerichtet. An der vorgegebenen Position innerhalb des Laserprojektors ist ein zusätzlicher, mit der Steuerungseinheit verbundener Photodetektor, beispielsweise eine Photodiode, ein Photowiderstand oder ein Phototransistor angeordnet. Der besondere Vorteil liegt darin, dass die Beweglichkeit des verkippbaren Spiegels durch ein regelmäßiges Signal überprüft werden kann, ohne dass bei der Erzeugung des regelmäßigen Signals Laserstrahlung den Laserprojektor verlässt und beispielsweise einen störenden leuchtenden Punkt auf der Verbundglasscheibe erzeugt. Ein Ausbleiben des regelmäßigen Signals auf dem Photodetektor innerhalb des Laserprojektors weist auf eine Beschädigung des verkippbaren Spiegels hin. In diesem Fall wird der Austritt von Laserstrahlung aus dem Laserprojektor vorteilhaft unterbrochen.

Die Vorrichtung zur Erzeugung eines Anzeigebildes auf einer Verbundglasscheibe wird bevorzugt als transparentes Display, besonders bevorzugt als Head-Up-Display in Gebäuden, Fahrzeugen, Flugzeugen, Hubschraubern und / oder Schiffen verwendet.

Die Erfindung wird anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein. Es zeigen:
- Fig. 1: eine schematische Darstellung einer erfindungsgemäßen Vorrichtung zur Erzeugung eines Anzeigebildes auf einer Verbundglasscheibe,
- Fig. 2: einen Schnitt entlang A-A' durch die Vorrichtung gemäß Figur 1,
- Fig. 3: einen Schnitt entlang A-A' durch eine weitere Ausgestaltung der erfindungsgemäßen Vorrichtung,
- Fig. 4: ein Diagramm der maximal zulässigen Bestrahlung in verschiedenen Wellenlängenbereichen,
- Fig. 5: ein Diagramm des Reflexionsgrades in Abhängigkeit vom Einfallswinkel,
- Fig. 6: eine schematische Darstellung der Reflexion von Laserstrahlung an einer Verbundglasscheibe und
- Fig. 7: ein detailliertes Flussdiagramm des erfindungsgemäßen Verfahrens.

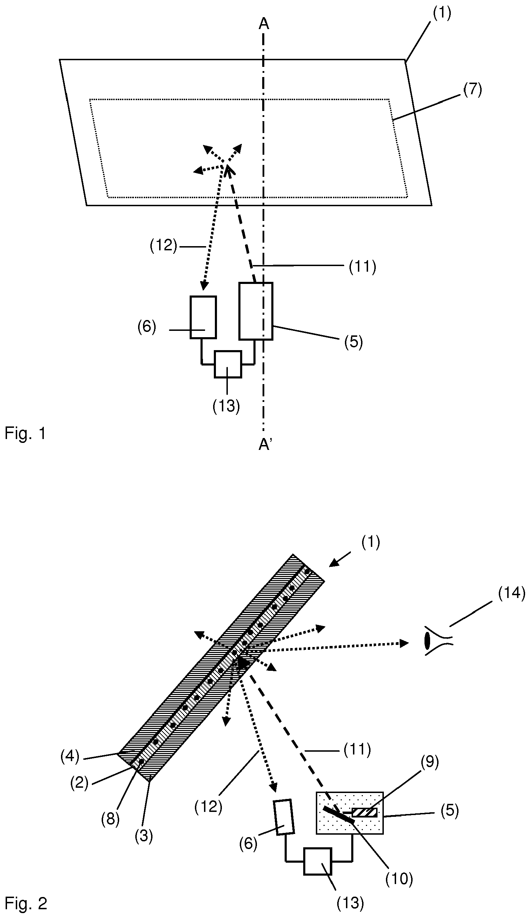

Fig. 1 und Fig. 2 zeigen je ein Detail einer erfindungsgemäßen Vorrichtung zur Erzeugung eines Anzeigebildes auf einer Verbundglasscheibe. Die Verbundglasscheibe 1 hat eine Breite von 150 cm und eine Höhe von 90 cm. Die Verbundglasscheibe 1 umfasst eine erste Scheibe 3 und eine zweite Scheibe 4 mit Dicken von 2,1 mm. Die Verbundglasscheibe 1 umfasst weiter eine Zwischenschicht 2 mit einer Dicke von 0,76 mm. Die Zwischenschicht 2 enthält PVB. Die Zwischenschicht 2 enthält weiter Diethyl-2,5-dihydroxyterephtalat als lumineszierendes Pigment 8. Das Diethyl-2,5-dihydroxyterephtalat wurde bei der Herstellung der Verbundglasscheibe 1 mit einer Konzentration von etwa 3 g/m² auf die Oberfläche der Zwischenschicht 2 aufgebracht.

Der Laserprojektor 5 enthält einen Laser 9 und ein optisches System 10 zur Lenkung der Laserstrahlung 11. Der Laser 9 ist ein Diodenlaser mit einer Emissionswellenlänge von 395 nm. Die Ausgangsleistung des Lasers 9 beträgt 200 mW. Die Lichttransmission durch die Verbundglasscheibe 1 beträgt bei der verwendeten Emissionswellenlänge des Lasers 9 aufgrund der Absorption durch das lumineszierende Pigment 8 weniger als 0,1 %. Dadurch wird eine Gefährdung von Personen durch Laserstrahlung, die durch die Verbundglasscheibe 1 transmittiert wird, vorteilhaft vermieden.

Das optische System 10 enthält einen MEMS-Mikroscanner. Durch den MEMS-Mikroscanner kann die Laserstrahlung 11 über die Verbundglasscheibe 1 bewegt werden. Die Bewegung der Laserstrahlung 11 ist innerhalb des Bereichs 7 der Verbundglasscheibe 1 möglich. Durch die Laserstrahlung 11 wird das lumineszierende Pigment 8 optisch angeregt. Das lumineszierende Pigment 8 gibt in der Folge Lumineszenzstrahlung 12 im Wellenlängenbereich des sichtbaren Lichts ab. Ein Teil der Lumineszenzstrahlung 12 gelangt auf das Auge des Betrachters 14 und wird als Bildpunkt auf der Verbundglasscheibe 1 wahrgenommen. Durch die Bewegung der Laserstrahlung 11 über die Verbundglasscheibe 1 wird ein Bild erzeugt, beispielsweise ein Piktogramm, eine Zahl oder ein Schriftzeichen.

Der Photodetektor 6 enthält eine Kamera mit Active Pixel Sensor. Durch die Verwendung geeigneter Spektralfilter kann die Kamera Licht in einem Wellenlängenbereich von 430 nm bis 480 nm detektieren. Die Kamera kann Lumineszenzstrahlung 12 des lumineszierenden Pigments 8 aus dem gesamten für die Laserstrahlung 11 zugänglichen Bereich 7 der Verbundglasscheibe 1 detektieren.

Der Photodetektor 6 und der Laserprojektor 5 sind an die Steuerungseinheit 13 angeschlossen. Die Steuerungseinheit 13 enthält eine anwendungsspezifische integrierte Schaltung (ASIC). Der Laserprojektor 5 übermittelt ein Ein-Signal an die Steuerungseinheit 13, wenn Laserstrahlung 11 den Laserprojektor 5 verlässt. Der Photodetektor 6 übermittelt ein Ein-Signal an die Steuerungseinheit 13, wenn Lumineszenzstrahlung 12 detektiert wird. Wenn Laserstrahlung 11 den Laserprojektor 5 verlässt, gleichzeitig aber keine Lumineszenzstrahlung 12 detektiert wird, muss sich ein Hindernis zwischen Laserprojektor 5 und Verbundglasscheibe 1 oder zwischen Photodetektor 6 und Verbundglasscheibe 1 befinden. In diesem Fall unterbricht die Steuerungseinheit 13 die Spannungsversorgung des Lasers 9. Eine Gefährdung des Betrachters 14 durch beispielsweise an dem Hindernis reflektierte Laserstrahlung 11 ist nicht mehr möglich.

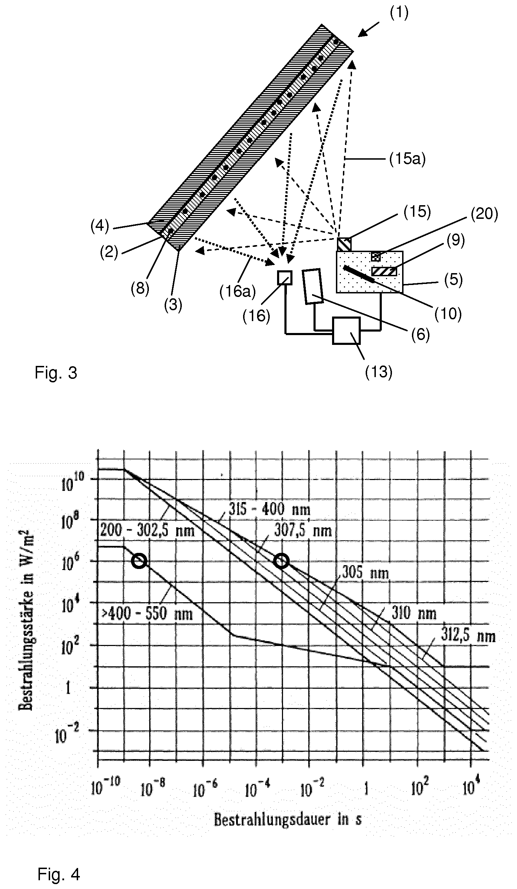

Fig. 3 zeigt einen Schnitt A-A' einer weiteren Ausgestaltung der erfindungsgemäßen Vorrichtung zur Erzeugung eines Anzeigebildes auf einer Verbundglasscheibe. Eine Infrarot-Strahlungsquelle 15 leuchtet den gesamten für die Laserstrahlung 11 zugänglichen Bereich 7 der Verbundglasscheibe 1 aus. Die Infrarot-Strahlungsquelle 15 ist nahe dem Strahlungsaustritt des Laserprojektors 5 angeordnet. Die Infrarot-Strahlungsquelle 15 enthält eine Glühlampe mit geeigneten Spektralfiltern und emittiert Infrarot-Strahlung 15a mit einer Wellenlänge von etwa 5 µm. Die Infrarot-Strahlung 15a wird an der Oberfläche der Verbundglasscheibe 1 reflektiert. Ein Infrarot-Photodetektor 16 detektiert bevorzugt die diffus reflektierten Anteile der Infrarot-Strahlung 16a aus dem für die Laserstrahlung 11 zugänglichen Bereich 7 der Verbundglasscheibe 1. Der Infrarot-Photodetektor 16 ist an die Steuerungseinheit 13 angeschlossen. Bei Auftreten einer plötzlichen Intensitätsänderung der detektierten Infrarot-Strahlung 16a, beispielsweise als Folge des plötzlichen Einbringens eines Hindernisses vor der Verbundglasscheibe 1, unterbricht die Steuerungseinheit 13 den Austritt von Laserstrahlung 11 aus dem Laserprojektor 5. Dazu unterbricht die Steuerungseinheit 13 beispielsweise die Spannungsversorgung des Lasers 9.

In einer alternativen Ausgestaltung der Erfindung detektiert der Infrarot-Photodetektor 16 die von der Verbundglasscheibe 1 ausgehende Wärmestrahlung. Eine plötzliche Änderung der detektierten Wärmestrahlung weist auf ein Hindernis vor der Verbundglasscheibe 1 hin. Die Steuerungseinheit 13 unterbricht in diesem Fall vorteilhaft den Austritt von Laserstrahlung 11 aus dem Laserprojektor 5. Eine Infrarot-Strahlungsquelle 15 ist dabei nicht notwendig.

Innerhalb des Laserprojektors 5 ist eine Photodiode als Photodetektor 20 angeordnet. Die Laserstrahlung 11 wird mit einer Frequenz von 30 Hz regelmäßig auf den Photodetektor 20 gerichtet. Der Photodetektor 20 ist mit der Steuerungseinheit 13 verbunden. Ein Unterbleiben des regelmäßigen Strahlungssignals auf dem Photodetektor 20 deutet auf eine Beschädigung des optischen Systems 10, insbesondere des verkippbaren Spiegels hin. In diesem Fall unterbricht die Steuerungseinheit 13 vorteilhaft den Austritt von Laserstrahlung 11 aus dem Laserprojektor 5.

Fig. 4 zeigt ein Diagramm der maximal zulässigen Bestrahlung in Abhängigkeit von der Bestrahlungsdauer für verschiedene Wellenlängenbereiche. Bei einer Bestrahlungsstärke von beispielsweise 1 x 10⁶ W/m² wird die maximal zulässige Bestrahlung im sichtbaren Wellenlängenbereich von >400 nm bis 700 nm nach etwa 5 x 10⁻⁹ s überschritten. Im UV-A-Wellenlängenbereich von 315 nm bis 400 nm wird die maximal zulässige Bestrahlung bei gleicher Bestrahlungsstärke erst nach etwa 1 x 10⁻³ s überschritten. Die beschriebenen Punkte sind in der Figur durch Kreise gekennzeichnet. Die Auftragung veranschaulicht den Vorteil eines Lasers 9 mit Emissionswellenlänge im UV-A-Bereich gegenüber einem Laser 9 mit Emissionswellenlänge im sichtbaren Bereich. Das Diagramm ist http://www2.physik.uni-Greifswald.de/sensoren/skripten/LASER11 .pdf entnommen.

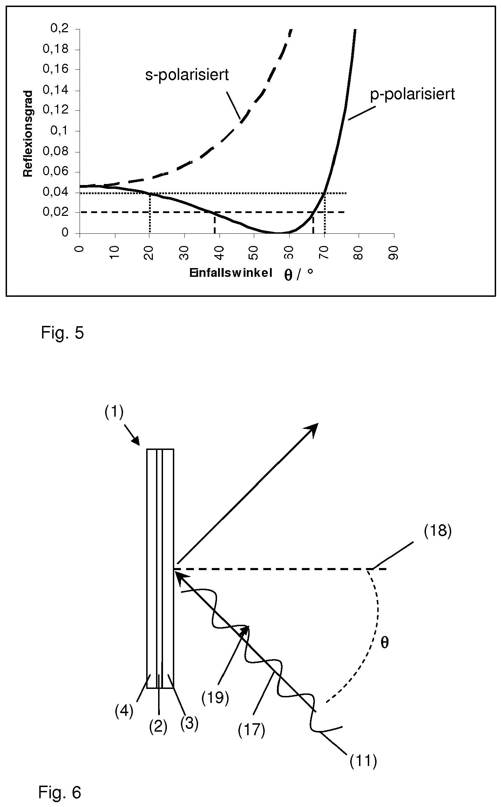

Fig. 5 zeigt ein Diagramm des Reflexionsgrades für p- und s-polarisierte Laserstrahlung 11 an einem Luft-Glas-Übergang in Abhängigkeit vom Einfallswinkel θ. Bei p-polarisierter Laserstrahlung 11 liegt der elektrische Feldvektor in der Einfallsebene, bei s-polarisierter Laserstrahlung 11 steht der elektrische Feldvektor senkrecht zur Einfallsebene. S-polarisiertes Licht wird stärker reflektiert als p-polarisiertes Licht. Für einen Einfallswinkel θ im Bereich von 20° bis 70° beträgt der Reflexionsgrad für p-polarisiertes Licht kleiner oder gleich 0,04. Für einen Einfallswinkel θ im Bereich von 38° bis 67° beträgt der Reflexionsgrad für p-polarisiertes Licht kleiner oder gleich 0,02. Die Werte für den Reflexionsgrad wurden dabei mit einem typischen Brechungsindex für Glas von 1,55 bei einer Standardwellenlänge von 589 nm berechnet. Die Werte für den Reflexionsgrad können in Abhängigkeit des verwendeten Materials der Scheibe und der verwendeten Laserwellenlänge leicht von den hier angegebenen Werten abweichen.

Fig. 6 veranschaulicht die geometrischen Parameter bei Reflexion von Laserstrahlung 11 an der Verbundglasscheibe 1. Die Ausbreitungsrichtung der auf die Verbundglasscheibe 1 treffenden Laserstrahlung 11 wird durch den Einfallsvektor 17 beschrieben. Der Einfallsvektor 17 und die Oberflächennormale 18 der Verbundglasscheibe 1 an der Stelle, an der die Laserstrahlung 11 auf die Oberfläche der Verbundglasscheibe 1 trifft, schließen den Einfallswinkel θ ein. Der Einfallsvektor 17 und die Oberflächennormale 18 spannen die Einfallsebene auf. Die Laserstrahlung 11 ist als periodische geschwungene Linie dargestellt, welche die Auslenkung des elektrischen Feldes in Richtung des elektrischen Feldvektors 19 veranschaulicht. Bei p-polarisierter Laserstrahlung 11 liegt der elektrische Feldvektor 19 in der Einfallsebene.

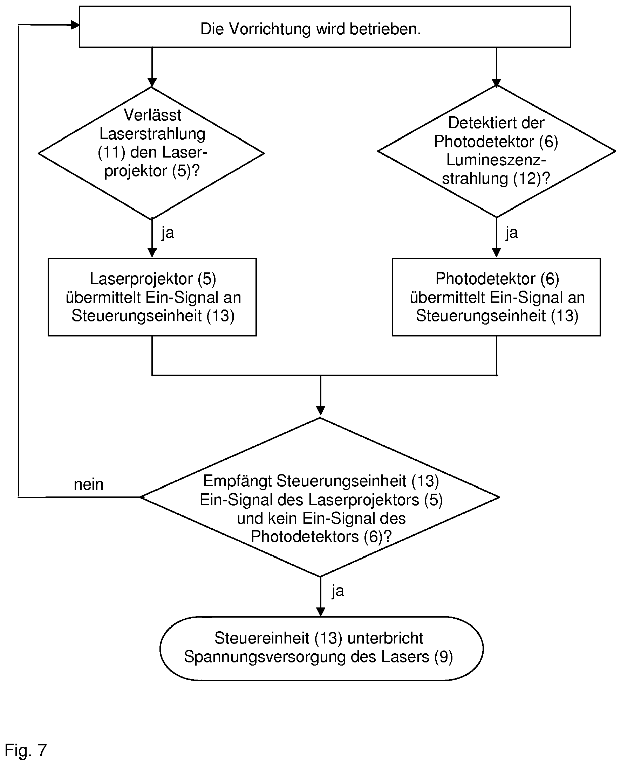

Fig. 7 zeigt beispielhaft das erfindungsgemäße Verfahren zur Erzeugung eines Anzeigebildes auf einer Verbundglasscheibe.

Eine Vorrichtung zur Erzeugung eines Anzeigebildes auf einer Verbundglasscheibe gemäß der Figur 1 wurde getestet. Es hat sich gezeigt, dass eine Schädigung des Auges eines Betrachters 14 durch an einem Hindernis reflektierte Laserstrahlung 11 verhindert werden kann. Dieses Ergebnis war für den Fachmann unerwartet und überraschend.

### Bezugszeichenliste

- (1): Verbundglasscheibe
- (2): Zwischenschicht der Verbundglasscheibe 1
- (3): erste Scheibe der Verbundglasscheibe 1
- (4): zweite Scheibe der Verbundglasscheibe 1
- (5): Laserprojektor
- (6): Photodetektor
- (7): Bereich der Verbundglasscheibe 1
- (8): lumineszierendes Pigment
- (9): Laser
- (10): optisches System zur Lenkung der Laserstrahlung 11
- (11): Laserstrahlung
- (12): Lumineszenzstrahlung
- (13): Steuerungseinheit
- (14): Betrachter
- (15): Infrarot-Strahlungsquelle
- (15a): Infrarot-Strahlung
- (16): Infrarot-Photodetektor
- (16a): Teil der reflektierten Infrarot-Strahlung
- (17): Einfallsvektor von Laserstrahlung 11 auf eine reflektierende Oberfläche
- (18): Flächennormale einer reflektierenden Oberfläche
- (19): elektrischer Feldvektor von linear polarisierter Strahlung
- (20): Photodetektor innerhalb des Laserprojektors 5

- θ: Einfallswinkel von Laserstrahlung 11 auf eine reflektierende Oberfläche

- A-A': Schnittlinie

## Patentansprüche

1. Eine Vorrichtung zur Erzeugung eines Anzeigebildes auf einer Verbundglasscheibe, umfassend:
- eine Verbundglasscheibe (1) mit einer ersten Scheibe (3) und einer zweiten Scheibe (4), die über eine zumindest ein lumineszierendes Pigment (8) enthaltende Zwischenschicht (2) miteinander verbunden sind,
- einen Laserprojektor (5), der zumindest einen Laser (9) und ein optisches System (10) zur Lenkung der Strahlung (11) des Lasers (9) enthält, wobei die Strahlung (11) auf die Verbundglasscheibe (1) innerhalb eines Bereichs (7) der Verbundglasscheibe (1) gerichtet wird,
- einen Photodetektor (6), der Lumineszenzstrahlung (12) des lumineszierenden Pigments (8) detektiert, wobei die Lumineszenzstrahlung (12) eine im Vergleich zur Laserstrahlung (11) andere Wellenlänge aufweist, und wobei der Photodetektor (6) so positioniert und ausgerichtet ist, dass die Lumineszenzstrahlung (12) mindestens aus dem gesamten für die Laserstrahlung (11) zugänglichen Bereich der Verbundglasscheibe (1) detektiert werden kann, und
- eine Steuerungseinheit (13), die den Photodetektor (6) und den Laserprojektor (5) elektronisch verbindet,
wobei die Steuerungseinheit (13) den Austritt der Strahlung (11) aus dem Laserprojektor (5) unterbricht, wenn keine Lumineszenzstrahlung (12) vom Photodetektor (6) detektiert wird;
**dadurch gekennzeichnet dass** der durch den Photodetektor detektierbare Wellenlängenbereich an den Wellenlängenbereich der Lumineszenzstrahlung des mindestens einen lumineszierenden Pigments durch einen Spektralfilter vor einer aktiven Fläche des Photodetektors angepasst ist.

2. Vorrichtung nach Anspruch 1, wobei der Photodetektor (6) zumindest eine Kamera mit einem zweidimensionalen Bildsensor, bevorzugt einem Active Pixel Sensor (APS), umfasst.

3. Vorrichtung nach Anspruch 1, wobei der Photodetektor (6) zumindest einen einpixeligen Photosensor, bevorzugt eine Photodiode umfasst.

4. Vorrichtung nach einem der Ansprüche 1 bis 3, wobei die Steuerungseinheit (13) die vom Laserprojektor (5) und vom Photodetektor (6) übermittelten Signale vergleicht.

5. Vorrichtung nach einem der Ansprüche 1 bis 4, wobei der Laserprojektor (5) einen Diodenlaser enthält und der Diodenlaser bevorzugt Strahlung (11) mit einer Wellenlänge von 360 nm bis 420 nm, besonders bevorzugt von 375 nm bis 400 nm emittiert.

6. Vorrichtung nach einem der Ansprüche 1 bis 5, wobei das optische System (10) zur Lenkung der Strahlung (11) zumindest einen MEMS-Mikroscanner enthält.

7. Vorrichtung nach einem der Ansprüche 1 bis 6, wobei die Strahlung (11) linear polarisiert ist mit einem Polarisationsverhältnis von zumindest 50:1, bevorzugt zumindest 90:1 und p-polarisiert auf die Verbundglasscheibe (1) trifft.

8. Vorrichtung nach Anspruch 7, wobei der Einfallswinkel Θ der Strahlung (11) beim Auftreffen auf die Verbundglasscheibe (1) von 20° bis 70°, bevorzugt von 38° bis 66° beträgt.

9. Vorrichtung nach einem der Ansprüche 1 bis 8, wobei der Laserprojektor (5) Strahlung (11) mit einer sich periodisch wiederholenden Pulsfolge aussendet.

10. Vorrichtung nach einem der Ansprüche 1 bis 9, die zusätzlich einen im Wellenlängenbereich von 4 µm bis 10 µm empfindlichen Infrarot-Photodetektor (16) umfasst.

11. Vorrichtung nach Anspruch 10, die eine Infrarot-Strahlungsquelle (15) umfasst, welche Infrarot-Strahlung (15a) innerhalb des Wellenlängenbereichs von 4 µm bis 10 µm emittiert.

12. Vorrichtung nach einem der Ansprüche 1 bis 11, die eine Ultraschallquelle und einen Ultraschall-Detektor umfasst.

13. Vorrichtung nach einem der Ansprüche 1 bis 12, wobei die Steuerungseinheit (13) zumindest eine integrierte Schaltung, bevorzugt eine anwendungsspezifische integrierte Schaltung (ASIC) umfasst.

14. Vorrichtung nach einem der Ansprüche 1 bis 13, wobei das lumineszierende Pigment (8) zumindest ein Hydroxyalkylterephthalat mit der chemischen Formel Rᵢ-COO-Ph(OH)ₓ-COO-R₂ enthält, wobei
Rᵢ, R₂ ein Alkyloder Allylrest mit 1 bis 10 C-Atomen ist,
Ph ein Phenylring ist, OH eine am Phenylring gebundene Hydroxylgruppe ist und
x eine ganze Zahl von 0 bis 4 ist,
bevorzugt Diethyl-2,5-dihydroxyterephthalat.

15. Vorrichtung nach einem der Ansprüche 1 bis 14, die einen Photodetektor (20), bevorzugt eine Photodiode, innerhalb des Laserprojektors (5) umfasst.

16. Vorrichtung nach einem der Ansprüche 1 bis 15, wobei auf der zum Laserprojektor (5) hingewandten Oberfläche der ersten Scheibe (3) eine Antireflex-Beschichtung angeordnet ist, die bevorzugt eine poröse Siliziumdioxid enthaltende Schicht umfasst.

17. Verfahren zur Erzeugung eines Anzeigebildes auf einer Verbundglasscheibe, wobei
- die Strahlung (11) eines Lasers (9) durch ein optisches System (10) eines Laserprojektors (5) auf eine zumindest ein lumineszierendes Pigment (8) enthaltende Verbundglasscheibe (1) gerichtet wird und vom Laserprojektor (5) ein Ein-Signal an eine Steuerungseinheit (13) übermittelt wird, wenn Laserstrahlung (11) den Laserprojektor (5) verlässt,
- von einem Photodetektor (6) ein Ein-Signal an die Steuerungseinheit (13) übermittelt wird, wenn Lumineszenzstrahlung (12) des lumineszierenden Pigments (8) aus dem für die Strahlung (11) des Lasers (9) zugänglichen Bereich (7) der Verbundglasscheibe (1) detektiert wird, wobei die Lumineszenzstrahlung (12) eine im Vergleich zur Laserstrahlung (11) andere Wellenlänge aufweist, und wobei der Photodetektor (6) so positioniert und ausgerichtet ist, dass die Lumineszenzstrahlung (12) mindestens aus dem gesamten für die Laserstrahlung (11) zugänglichen Bereich der Verbundglasscheibe (1) detektiert werden kann, und
- die Steuerungseinheit (13) den Austritt von Laserstrahlung (11) aus dem Laserprojektor (5) unterbricht, wenn das Ein-Signal des Laserprojektors (5) und gleichzeitig kein Ein-Signal des Photodetektors (6) von der Steuerungseinheit (13) empfangen wird;
**dadurch gekennzeichnet dass**
der durch den Photodetektor detektierbare Wellenlängenbereich an den Wellenlängenbereich der Lumineszenzstrahlung des mindestens einen lumineszierenden Pigments durch einen Spektralfilter vor einer aktiven Fläche des Photodetektors angepasst ist.

18. Verfahren nach Anspruch 17, wobei
- die Strahlung (11) in regelmäßigen Zeitabständen auf eine vorgegebene Position bevorzugt im Randbereich des für die Strahlung (11) zugänglichen Bereichs (7) gerichtet wird,
- mittels einer Kamera mit einem zweidimensionalen Bildsensor, bevorzugt einem Active Pixel Sensor, als Photodetektor (6) das Auftreten des regelmäßigen Lumineszenzsignals von der vorgegebenen Position auf der Verbundglasscheibe (1) überprüft wird und
- die Steuerungseinheit (13) den Austritt von Laserstrahlung (11) aus dem Laserprojektor (5) unterbricht, wenn das regelmäßige Lumineszenzsignal von der vorgegebenen Position auf der Verbundglasscheibe (1) nicht detektiert wird.

19. Verfahren nach Anspruch 17, wobei
- die Strahlung (11) in regelmäßigen Zeitabständen auf eine vorgegebene Position innerhalb des Laserprojektors (5) gerichtet wird,
- mittels eines Photodetektors (20) innerhalb des Laserprojektors (5) das Auftreten des regelmäßigen Strahlungssignals überprüft wird und
- die Steuerungseinheit (13) den Austritt von Laserstrahlung (11) aus dem Laserprojektor (5) unterbricht, wenn das regelmäßige Strahlungssignal von dem Photodetektor (20) nicht detektiert wird.

20. Verwendung einer Vorrichtung zur Erzeugung eines Anzeigebildes auf einer Verbundglasscheibe nach einem der Ansprüche 1 bis 16 als transparentes Display, bevorzugt als Head-Up-Display in Gebäuden, Fahrzeugen, Flugzeugen, Hubschraubern und / oder Schiffen.

## Claims

1. A device for generating a display image on a laminated glass pane, comprising:
- a laminated glass pane (1) having a first pane (3) and a second pane (4) which are connected to one another by an intermediate layer (2) containing at least one luminescent pigment (8),
- a laser projector (5) which contains at least one laser (9) and an optical system (10) for directing the radiation (11) of the laser (9), the radiation (11) being directed onto the laminated glass pane (1) within a region of (7) the laminated glass pane (1),
- a photodetector (6) which detects luminescent radiation (12) of the luminescent pigment (8), the luminescent radiation (12) having a different wavelength to the laser radiation (11), and the photodetector (6) being positioned and oriented such that the luminescent radiation (12) can be detected at least from the entire region of the laminated glass pane (1) that is accessible to the laser radiation (11), and
- a control unit (13) which electronically connects the photodetector (6) and the laser projector (5),
the control unit (13) interrupting the emission of the radiation (11) from the laser projector (5) when no luminescent radiation (12) is detected by the photodetector (6);
**characterized in that** the wavelength range which can be detected by the photodetector is matched to the wavelength range of the luminescent radiation of the at least one luminescent pigment by means of a spectral filter in front of an active surface of the photodetector.

2. The device as claimed in claim 1, wherein the photodetector (6) comprises at least one camera having a two-dimensional image sensor, preferably an active pixel sensor (APS).

3. The device as claimed in claim 1, wherein the photodetector (6) comprises at least one single-pixel photosensor, preferably a photodiode.

4. The device as claimed in any of claims 1 to 3, wherein the control unit (13) compares the signals transmitted by the laser projector (5) and by the photodetector (6).

5. The device as claimed in any of claims 1 to 4, wherein the laser projector (5) contains a diode laser and the diode laser preferably emits radiation (11) having a wavelength of from 360 nm to 420 nm, particularly preferably from 375 nm to 400 nm.

6. The device as claimed in any of claims 1 to 5, wherein the optical system (10) for directing the radiation (11) contains at least one MEMS microscanner.

7. The device as claimed in any of claims 1 to 6, wherein the radiation (11) is linearly polarized with a polarization ratio of at least 50:1, preferably at least 90:1, and impinges on the laminated glass pane (1) in a p-polarized manner.

8. The device as claimed in claim 7, wherein the angle of incidence Θ of the radiation (11) when said radiation impinges on the laminated glass pane (1) is from 20° to 70°, preferably from 38° to 66°.

9. The device as claimed in any of claims 1 to 8, wherein the laser projector (5) emits radiation (11) in a periodically repeating pulse sequence.

10. The device as claimed in any of claims 1 to 9, additionally comprising an infrared photodetector (16) which is sensitive in a wavelength range of from 4 µm to 10 µm.

11. The device as claimed in claim 10, comprising an infrared radiation source (15) which emits infrared radiation (15a) within the wavelength range of from 4 µm to 10 µm.

12. The device as claimed in any of claims 1 to 11, comprising an ultrasound source and an ultrasound detector.

13. The device as claimed in any of claims 1 to 12, wherein the control unit (13) comprises at least one integrated circuit, preferably an application-specific integrated circuit (ASIC).

14. The device as claimed in any of claims 1 to 13, wherein the luminescent pigment (8) contains at least one hydroxyalkyl terephthalate having the chemical formula Rᵢ-COO-Ph(OH)ₓ-COO-R₂, wherein
Rᵢ, R₂ is an alkyl or allyl radical having 1 to 10 carbon atoms,
Ph is a phenyl ring, OH is a hydroxyl group bonded to the phenyl ring, and
x is an integer from 0 to 4,
preferably diethyl 2,5-dihydroxy terephthalate.

15. The device as claimed in any of claims 1 to 14, comprising a photodetector (20), preferably a photodiode, inside the laser projector (5).

16. The device as claimed in any of claims 1 to 15, wherein an anti-reflective coating is arranged on the surface of the first pane (3) that faces the laser projector (5), which coating preferably comprises a layer which contains porous silicon dioxide.

17. A method for generating a display image on a laminated glass pane, in which
- the radiation (11) of a laser (9) is directed onto a laminated glass pane (1) which contains at least one luminescent pigment (8) by an optical system (10) of a laser projector (5), and an on-signal is transmitted to a control unit (13) by the laser projector (5) when laser radiation (11) leaves the laser projector (5),
- an on-signal is transmitted to the control unit (13) by a photodetector (6) when luminescent radiation (12) of the luminescent pigment (8) is detected from the region (7) of the laminated glass pane (1) that is accessible to the radiation (11) of the laser (9), the luminescent radiation (12) having a different wavelength to the laser radiation (11), and the photodetector (6) being positioned and oriented such that the luminescent radiation (12) can be detected at least from the entire region of the laminated glass pane (1) that is accessible to the laser radiation (11), and
- the control unit (13) interrupts the emission of laser radiation (11) from the laser projector (5) if the on-signal from the laser projector (5) is received by the control unit (13) at the same time as no on-signal from the photodetector (6) is received by said unit;
**characterized in that** the wavelength range which can be detected by the photodetector is matched to the wavelength range of the luminescent radiation of the at least one luminescent pigment by means of a spectral filter in front of an active surface of the photodetector.

18. The method as claimed in claim 17, wherein
- the radiation (11) is directed at a predetermined position at regular time intervals, which position is preferably in the edge region of the region (7) which is accessible to the radiation (11),
- the occurrence of the regular luminescence signal from the predetermined position on the laminated glass pane (1) is checked by means of a camera having a two-dimensional image sensor, preferably an active pixel sensor, as a photodetector (6), and
- the control unit (13) interrupts the emission of laser radiation (11) from the laser projector (5) if the regular luminescence signal from the predetermined position on the laminated glass pane (1) is not detected.

19. The method as claimed in claim 17, wherein
- the radiation (11) is directed at a predetermined position within the laser projector (5) at regular time intervals,
- the occurrence of the regular radiation signal is checked by means of a photodetector (20) within the laser projector (5), and
- the control unit (13) interrupts the emission of laser radiation (11) from the laser projector (5) if the regular radiation signal is not detected by the photodetector (20).

20. A use of a device for generating a display image on a laminated glass pane as claimed in any of claims 1 to 16 as a transparent display, preferably as a head-up display in buildings, vehicles, aircraft, helicopters and/or ships.

## Revendications

1. Dispositif destiné à générer une image d'affichage sur une vitre en verre feuilleté, comprenant :
- une vitre en verre feuilleté (1) comportant une première vitre (3) et une seconde vitre (4) reliées entre elles par une couche intermédiaire (2) contenant au moins un pigment luminescent (8),
- un projecteur laser (5), lequel contient au moins un laser (9) et un système optique (10) destiné à diriger le rayonnement (11) du laser (9), le rayonnement (11) étant pointé sur la vitre en verre feuilleté (1) dans une zone (7) de la vitre en verre feuilleté (1),
- un photodétecteur (6), lequel détecte un rayonnement luminescent (12) du pigment luminescent (8), le rayonnement luminescent (12) ayant une longueur d'onde différente en comparaison du rayonnement laser (11), et le photodétecteur (6) étant positionné et orienté de sorte que le rayonnement luminescent (12) peut être détecté au moins à partir de toute la zone de la vitre en verre feuilleté (1) accessible au rayonnement laser (11), et
- une unité de commande (13), laquelle relie électroniquement le photodétecteur (6) et le projecteur laser (5),
l'unité de commande (13) interrompant la sortie du rayonnement (11) du projecteur laser (5) si aucun rayonnement luminescent (12) du photodétecteur (6) n'est détecté ;
**caractérisé en ce que**
la plage de longueurs d'onde détectable par le photodétecteur est adaptée à la plage de longueurs d'onde du rayonnement luminescent de l'au moins un pigment luminescent par un filtre spectral devant une surface active du photodétecteur.

2. Dispositif selon la revendication 1, dans lequel le photodétecteur (6) comprend au moins une caméra comportant un capteur d'image bidimensionnel, de préférence un capteur de pixel actif (APS).

3. Dispositif selon la revendication 1, dans lequel le photodétecteur (6) comprend au moins un photodétecteur à pixel unique, de préférence une photodiode.

4. Dispositif selon l'une des revendications 1 à 3, dans lequel l'unité de commande (13) compare les signaux transmis par le projecteur laser (5) et par le photodétecteur (6).

5. Dispositif selon l'une des revendications 1 à 4, dans lequel le projecteur laser (5) contient un laser à diode, et le laser à diode émet de préférence un rayonnement (11) d'une longueur d'onde de 360 nm à 420 nm, de manière particulièrement préférée de 375 nm à 400 nm.

6. Dispositif selon l'une des revendications 1 à 5, dans lequel le système optique (10) destiné à diriger le rayonnement (11) contient au moins un microscanner MEMS.

7. Dispositif selon l'une des revendications 1 à 6, dans lequel le rayonnement (11) est polarisé linéairement avec un rapport de polarisation d'au moins 50:1, de préférence d'au moins 90:1, et frappe la vitre en verre feuilleté (1) à l'état de polarisation p.

8. Dispositif selon la revendication 7, dans lequel l'angle d'incidence Θ du rayonnement (11), lorsqu'il frappe la vitre en verre feuilleté (1), est de 20 ° à 70 °, de préférence de 38 ° à 66 °.

9. Dispositif selon l'une des revendications 1 à 8, dans lequel le projecteur laser (5) émet un rayonnement (11) avec une séquence d'impulsions se répétant périodiquement.

10. Dispositif selon l'une des revendications 1 à 9, qui comprend en outre un photodétecteur infrarouge (16) sensible dans la plage de longueurs d'onde de 4 µm à 10 µm.

11. Dispositif selon la revendication 10, qui comprend une source de rayonnement infrarouge (15) qui émet un rayonnement infrarouge (15a) dans la plage de longueurs d'onde de 4 µm à 10 µm.

12. Dispositif selon l'une des revendications 1 à 11, qui comprend une source ultrasonore et un détecteur ultrasonore.

13. Dispositif selon l'une des revendications 1 à 12, dans lequel l'unité de commande (13) comprend au moins un circuit intégré, de préférence un circuit intégré spécifique à l'application (ASIC).

14. Dispositif selon l'une des revendications 1 à 13, dans lequel le pigment luminescent (8) contient au moins un hydroxyalkyltéréphtalate de formule chimique Rᵢ-COO-Ph(OH)ₓ-COO-R₂, où
Rᵢ, R₂ est un radical alkyle ou allyle ayant 1 à 10 atomes de carbone,
Ph est un cycle phényle, OH est un groupe hydroxyle attaché au cycle phényle et
x est un nombre entier de 0 à 4,
de préférence le diéthyl-2,5-dihydroxytéréphtalate.

15. Dispositif selon l'une des revendications 1 à 14, qui comprend un photodétecteur (20), de préférence une photodiode, à l'intérieur du projecteur laser (5).

16. Dispositif selon l'une des revendications 1 à 15, dans lequel un revêtement antireflet est disposé sur la surface de la première vitre (3) tournée face au projecteur laser (5), qui comprend de préférence une couche contenant du dioxyde de silicium poreux.

17. Procédé de génération d'une image d'affichage sur une vitre en verre feuilleté, dans lequel
- le rayonnement (11) d'un laser (9) est dirigé à travers un système optique (10) d'un projecteur laser (5) sur une vitre en verre feuilleté (1) contenant au moins un pigment luminescent (8), et un signal de marche est transmis du projecteur laser (5) à une unité de commande (13) lorsque le rayonnement laser (11) quitte le projecteur laser (5),
- un signal de marche est transmis d'un photodétecteur (6) à l'unité de commande (13) lorsque le rayonnement luminescent (12) du pigment luminescent (8) de la zone (7) de la vitre en verre feuilleté (1) accessible au rayonnement (11) du laser (9) est détecté, le rayonnement luminescent (12) présentant une longueur d'onde différente en comparaison de celle du rayonnement laser (11), et le photodétecteur (6) étant positionné et orienté de sorte que le rayonnement luminescent (12) peut être détecté au moins à partir de toute la zone de la vitre en verre feuilleté (1) accessible au rayonnement laser (11), et
- l'unité de commande (13) interrompt la sortie du rayonnement laser (11) du projecteur laser (5) lorsque l'unité de commande (13) reçoit le signal de marche du projecteur laser (5) et ne reçoit simultanément aucun signal de marche du photodétecteur (6) ;
**caractérisé en ce que**
la plage de longueurs d'onde détectable par le photodétecteur est adaptée à la plage de longueurs d'onde du rayonnement luminescent de l'au moins un pigment luminescent par un filtre spectral devant une surface active du photodétecteur.

18. Procédé selon la revendication 17, dans lequel
- le rayonnement (11) est dirigé à des intervalles de temps réguliers vers une position prédéterminée, de préférence dans la zone de bord de la zone (7) accessible au rayonnement (11),
- l'apparition du signal de luminescence régulier à partir de la position prédéterminée sur la vitre en verre feuilleté (1) est vérifiée au moyen d'une caméra comportant un capteur d'image bidimensionnel, de préférence un capteur de pixel actif, en tant que photodétecteur (6) et
- l'unité de commande (13) interrompt la sortie du rayonnement laser (11) du projecteur laser (5), si le signal de luminescence régulier de la position prédéterminée sur la vitre en verre feuilleté (1) n'est pas détecté.

19. Procédé selon la revendication 17, dans lequel
- le rayonnement (11) est dirigé vers une position prédéterminée à l'intérieur du projecteur laser (5) à des intervalles de temps réguliers,
- l'apparition du signal de rayonnement régulier est vérifiée au moyen d'un photodétecteur (20) à l'intérieur du projecteur laser (5) et
- l'unité de commande (13) interrompt la sortie du rayonnement laser (11) du projecteur laser (5), si le signal de rayonnement régulier n'est pas détecté par le photodétecteur (20).

20. Utilisation d'un dispositif pour générer une image d'affichage sur une vitre en verre feuilleté selon l'une des revendications 1 à 16 comme écran transparent, de préférence comme affichage tête haute dans des bâtiments, des véhicules, des avions, des hélicoptères et/ou des navires.
